(19)

Europäisches
Patentamt
European
Patent Office
Office européen
des brevets

(11) **EP 4 660 673 A1**

(12) **EUROPEAN PATENT APPLICATION**

(43) Date of publication:
**10.12.2025 Bulletin 2025/50**

(21) Application number: **25172723.6**

(22) Date of filing: **25.04.2025**

(51) International Patent Classification (IPC):
**G02B 6/12** (2006.01)      **G02B 6/42** (2006.01)
**H10F 39/10** (2025.01)      G02B 6/122 (2006.01)

(52) Cooperative Patent Classification (CPC):
**G02B 6/4204; G02B 6/12002; G02B 6/12004;**
**H10F 39/103;** G02B 6/1228; G02B 6/4206;
G02B 6/421; H10F 77/413

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **30.04.2024 US 202463640313 P**

(71) Applicant: **Ranovus Inc.**
**Kanata, Ontario K2K 2X1 (CA)**

(72) Inventors:
• **Shiran, Hatef**
**Ottawa, Ontario, K2K 0H3 (CA)**
• **Beckett, Douglas J. S.**
**Kanata, Ontario, K2L 1Z3 (CA)**
• **Huante-Ceron, Edgar**
**Stittsville, Ontario, K2S 0G2 (CA)**
• **Jafari, Omid**
**Ottawa, Ontario, K2W 0B2 (CA)**
• **Grzybowski, Richard**
**New York, 14830 (US)**

(74) Representative: **Eder Schieschke & Partner mbB**
**Patentanwälte**
**Elisabethstraße 34**
**80796 München (DE)**

Remarks:
Claims 17 to 20 are deemed to be abandoned due to non-payment of the claims fees (Rule 45(3) EPC).

(54) **PHOTODIODES WITH CARRIER SCREENING MITIGATION**

(57)      A photodiode includes an input waveguide, a photodiode component comprising a photodiode material, and an optical coupling waveguide. The input waveguide and the optical coupling waveguide are optically coupled to each other at respective ends external to the photodiode component. The optical coupling waveguide is positioned adjacent to the photodiode material along at least a portion of its length and is optically coupled to the photodiode material along at least part of that length. This configuration enables guided optical signals to be coupled from the input waveguide through the optical coupling waveguide and into the photodiode material for efficient photodetection.

FIG. 3A

## Description

### CROSS-REFERENCE TO RELATED APPLICATIONS

The present specification claims priority from United States Provisional Patent Application Number 63/640313, filed on April 30, 2024, which is incorporated herein by reference.

### FIELD

The present specification relates generally to telecommunication devices, and specifically to photodiodes with carrier screening mitigation.

### BACKGROUND

Photodiode saturation (e.g., deviation of linearity with increase of optical power) is often explained as being due to the reduction in the electric field in the absorbing region . This electric field reduction is caused by "carrier screening", which results in reduction of optoelectronic bandwidth of the photodiode. At low optical input powers, charge carriers (electrons/holes pairs), generated by the absorption of light, are effectively separated and collected by the built-in electric field of the photodiode. However, at high optical input powers, the photogenerated carrier density becomes so large that the carriers cannot be removed quickly enough. As a result, they begin to accumulate within the device, creating their own electric field that opposes the electric field applied through the photodiode; this effect is known as carrier screening. The carrier screening effect results in a nonlinearity in photocurrent and degrades bandwidth (speed) at high input powers. Photodiode linearity can be increased at the expense of responsivity; for example, a diode may be engineered to reduce the amount of light absorbed (e.g., fewer charge carriers per unit volume). However, reducing the amount of light absorbed increases photocurrent and bandwidth linearity at the expense of reduced responsivity.

### SUMMARY

A first aspect of the specification provides a photodiode comprising an input waveguide, a photodiode component, and an optical coupling waveguide. The input waveguide and the optical coupling waveguide are optically coupled to each other at respective ends external to the photodiode component. The optical coupling waveguide is adjacent a photodiode material of the photodiode component, at least partially along a length of the photodiode material. The optical coupling waveguide and the photodiode material are optically coupled at least partially along the length of the photodiode material.

In some examples of the first aspect, one or more of the following may be true: the input waveguide and the photodiode material of the photodiode material do not overlap; the input waveguide is not optically coupled to the photodiode material of the photodiode material; and the input waveguide does not input light to the photodiode material of the photodiode material.

In some examples of the first aspect, the photodiode material has a higher index of refraction than the optical coupling waveguide.

In some examples of the first aspect, one or more of the following may apply: the input waveguide is tapered, narrowing along a longitudinal axis, and along the optical coupling waveguide; and the input waveguide has an effective index of refraction that decreases along the longitudinal axis, and along the optical coupling waveguide.

In some examples of the first aspect, one or more of the following may apply: the optical coupling waveguide is tapered, narrowing along a longitudinal axis, and along the photodiode material; and the optical coupling waveguide has an effective index of refraction that decreases along the longitudinal axis, and along the photodiode material.

In some examples of the first aspect, one or more of the following may apply: the photodiode material is tapered, widening along a longitudinal axis, and along the optical coupling waveguide; and the photodiode material has an effective index of refraction that increases along the longitudinal axis, and along the optical coupling waveguide.

In some examples of the first aspect, one or more of the following may apply: the input waveguide is tapered, narrowing along a longitudinal axis, and along the optical coupling waveguide; the optical coupling waveguide is tapered, narrowing along the longitudinal axis, and along the photodiode material; and the photodiode material is tapered, widening along the longitudinal axis, and along the optical coupling waveguide.

In some examples of the first aspect, one or more of the following may apply: the input waveguide has an effective index of refraction that decreases along a longitudinal axis, and along the optical coupling waveguide; the optical coupling waveguide has a respective effective index of refraction that decreases along the longitudinal axis, and along the photodiode material; and the photodiode material has a respective further effective index of refraction that increases along the longitudinal axis, and along the optical coupling waveguide.

In some examples of the first aspect, the photodiode further comprises a substrate, wherein the optical coupling waveguide is over the photodiode material, relative to the substrate, and one of: over the input waveguide, relative to the substrate; below the input waveguide, relative to the substrate; and side-by-side with the input waveguide, relative to the substrate.

In some examples of the first aspect, the photodiode further comprises a sealing layer between a length of the photodiode material and the optical coupling waveguide, the sealing layer configured to not alter properties of light of a wavelength carried by the input waveguide.

A second aspect of the specification provides a photodiode comprising an input waveguide and a photodiode component, wherein the input waveguide is adjacent a structure of a photodiode material of the photodiode component, at least partially along a length of the structure of the photodiode material. A gap between the input waveguide and the structure of the photodiode material decreases along a longitudinal axis of the structure, such that, as the gap narrows, more light is coupled from the input waveguide into the structure of the photodiode material.

In some examples of the second aspect, the photodiode further comprises an additional input waveguide adjacent the structure of the photodiode material. The additional input waveguide is located at an end of the structure of the photodiode material opposite the input waveguide, and is located at least partially along the length of the structure of the photodiode material. A respective gap between the additional input waveguide and the structure of the photodiode material decreases along the longitudinal axis of the structure of the photodiode material, such that, as the respective gap narrows, more respective light is coupled from the additional input waveguide into the structure of the photodiode material.

In some examples of the second aspect, the photodiode further comprises an additional input waveguide adjacent the structure of the photodiode material. The additional input waveguide is located at a side of the structure of the photodiode material opposite the input waveguide, and is located at least partially along the length of the structure of the photodiode material. A respective gap between the additional input waveguide and the structure of the photodiode material decreases along the longitudinal axis of the structure of the photodiode material, such that, as the respective gap narrows, more light is coupled from the additional input waveguide into the structure of the photodiode material.

In some examples of the second aspect, the gap is narrowest at about a center of the structure of the photodiode material, and thereafter increases along the longitudinal axis.

In some examples of the second aspect, the photodiode further comprises an additional input waveguide adjacent the structure of the photodiode material. The additional input waveguide is located at a side of the structure of the photodiode material opposite the input waveguide, and is located at least partially along the length of the structure of the photodiode material. A respective gap between the additional input waveguide and the structure of the photodiode material decreases along the longitudinal axis of the structure of the photodiode material, such that, as the respective gap narrows, more light is coupled from the additional input waveguide into the structure of the photodiode material. The respective gap is narrowest at about the center of the structure of the photodiode material, and thereafter increases along the longitudinal axis.

A third aspect of the specification provides a photodiode comprising an input waveguide and a structure of photodiode material. The input waveguide and the structure of photodiode material are optically coupled to each other at least partially along a length of the structure of photodiode material. The input waveguide includes one or more grooved regions to reduce an effective index of refraction of the input waveguide adjacent the structure of photodiode material, thereby promoting transfer of light from the input waveguide into the structure of the photodiode material.

In some examples of the third aspect, the structure of photodiode material includes a horseshoe-shaped region. The input waveguide is tapered to fit between arms of the horseshoe-shaped region of the structure of the photodiode material. The one or more grooved regions comprise respective grooved regions on opposite sides of the input waveguide, and adjacent respective arms of the horseshoe-shaped region of the structure of photodiode material.

In some examples of the third aspect, the one or more grooved regions are filled with one or more of dielectric material and transparent material to reduce the effective index of refraction of the input waveguide adjacent the structure of photodiode material.

In some examples of the third aspect, the structure of the photodiode material comprises respective layers of contacts on opposite sides of the photodiode material.

In some examples of the third aspect, the photodiode further comprises a second input waveguide at an end of the structure of the photodiode material opposite the input waveguide. The structure of the photodiode material comprises respective horseshoe-shaped regions at opposite ends joined by a straight region. The input waveguide and the second input waveguide are respectively tapered to fit between respective arms of the respective horseshoe-shaped regions of the structure of the photodiode material. The one or more grooved regions comprise respective grooved regions on respective opposite sides of the input waveguide and the second input waveguide, adjacent the respective arms of the respective horseshoe-shaped regions of the structure of photodiode material.

## BRIEF DESCRIPTIONS OF THE DRAWINGS

For a better understanding of the various implementations described herein and to show more clearly how they may be carried into effect, reference will now be made, by way of example only, in which:

FIG. 1A depicts a top view and an in-plane view (e.g., cross-section through line A-A' of the top view) of a Si-Ge-Si photodiode, according to the prior art.
FIG. 1B a graph of photodiode absorption rate, of the photodiode of FIG. 1A, as a function of length along a propagation axis of the photodiode, according to the prior art.

FIG. 1C a graph of bandwidth of the photodiode of FIG. 1A, as a function of input power, according to the prior art.

FIG. 2A depicts graph of simulated photodiode current as a function of optical input power in different sequential sections (strips) at increasing distances from an input of the photodiode of FIG, 1A, according to the prior art.

FIG. 2B depicts graph of simulated total photodiode current for a TE mode of light input to the photodiode of FIG. 1A, as a function of optical input power photodiode, including simulated total photodiode current, according to the prior art.

FIG. 3A depicts a schematic top view of a photodiode with carrier screening mitigation, according to present examples.

FIG. 3B depicts a cross-section of the photodiode of FIG. 3A through a line B-B', according to present examples.

FIG. 3C depicts a cross-section of a portion of the photodiode of FIG. 3A through a line C-C', according to present examples.

FIG. 4 depicts a graph of absorbed power as a function of length along a propagation axis of the photodiode of FIG. 1A, according to the prior art, and a graph of absorbed power as a function of length along a propagation axis of the photodiode of FIG. 3A, according to present examples.

FIG. 5A depicts a graph of propagating light electric field in the photodiode of FIG. 1A, as a function of length along a propagation axis of the photodiode of FIG. 1A, according to the prior art.

FIG. 5B depicts a graph of propagating light electric field in the photodiode of FIG. 3A, as a function of length along a propagation axis of the photodiode of FIG. 1A, according to the present examples.

FIG. 6A depicts a graph of simulated bandwidth as a function of input power at a bias of -1.5 V, for the photodiode of FIG. 3A, according to the present examples.

FIG. 6B depicts a graph of simulated bandwidth as a function of input power at a bias of -1 V, for the photodiode of FIG. 3A, according to the present examples.

FIG. 7 depicts a graph of PD output current as a function of optical input power (e.g., responsivity) at a -1 volt bias, for the photodiode of FIG. 3A, according to the present examples.

FIG. 8 depicts a schematic top view of a photodiode with carrier screening mitigation, according to other present examples.

FIG. 9 depicts a schematic top view of a photodiode with carrier screening mitigation, according to other present examples.

FIG. 10 depicts a schematic top view of a photodiode with carrier screening mitigation, according to other present examples.

FIG. 11 depicts a schematic top view of a dual-input photodiode with carrier screening mitigation, according to other present examples.

FIG. 12 depicts a schematic top view of another photodiode with carrier screening mitigation, according to present examples.

FIG. 13 depicts the components of the photodiode of FIG. 12 in an exploded view to better show shapes thereof, according to present examples.

FIG. 14A depicts a cross-section of a portion of the photodiode of FIG. 12 through a line A-A', according to present examples.

FIG. 14B depicts a cross-section of a portion of the photodiode of FIG. 12 through a line B-B', according to present examples.

FIG. 14C depicts a cross-section of a portion of the photodiode of FIG. 12 through a line C-C', according to present examples.

FIG. 15 depicts a graph of bandwidth as a function of input power at a bias of -1 V, for the photodiode of FIG. 12, according to the present examples.

FIG. 16 depicts a schematic top view of an alternative optical structure of optically coupling an input waveguide to a structure of photodiode material, according to present examples.

FIG. 17 depicts a schematic top view of an alternative optical structure of optically coupling an input waveguide to a structure of photodiode material, according to present examples.

FIG. 18 depicts a schematic top view of an alternative optical structure of optically coupling an input waveguide to a structure of photodiode material, according to present examples.

FIG. 19 depicts a schematic top view of an alternative optical structure of optically coupling an input waveguide to a structure of photodiode material, according to present examples.

FIG. 20 depicts a schematic top view of an alternative optical structure of optically coupling an input waveguide to a structure of photodiode material, according to present examples.

FIG. 21 depicts a schematic top view of yet another photodiode with carrier screening mitigation, according to present examples.

FIG. 22A depicts a cross-section of a portion of the photodiode of FIG. 21 through a line A-A', according to present examples.

FIG. 22B depicts a cross-section of a portion of the photodiode of FIG. 21 through a line B-B', according to present examples.

FIG. 22C depicts a cross-section of a portion of the photodiode of FIG. 21 through a line C-C', according to present examples.

FIG. 22D depicts a cross-section of a portion of the photodiode of FIG. 21 through a line D-D', according to present examples.

## DETAILED DESCRIPTION

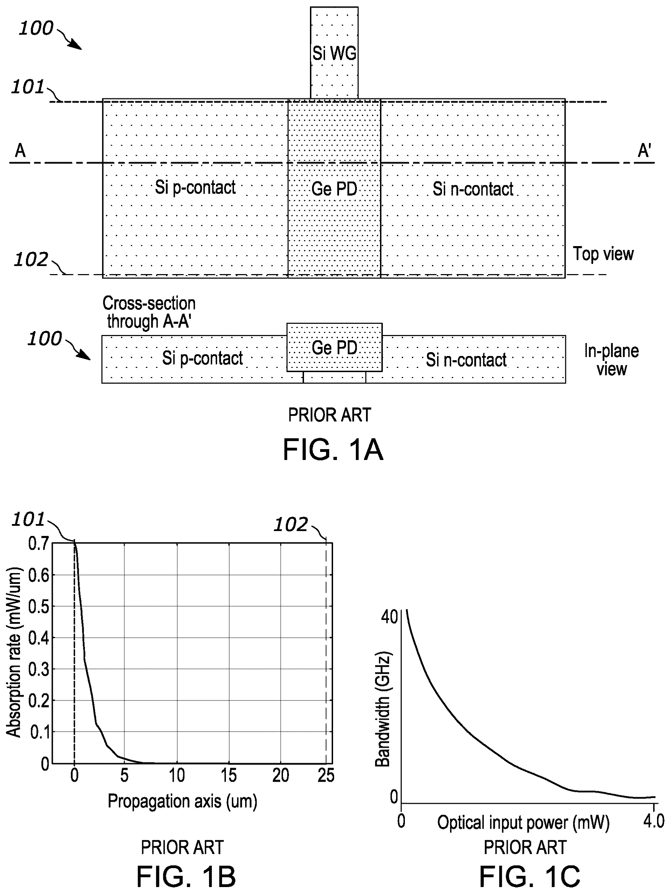

Attention is first directed to FIG. 1A, which depicts a top view and an in-plane cross-sectional view (through a line A-A') of one possible example of a Si-Ge-Si (Silicon-Germanium-Silicon) heterostructure photodiode 100 with abrupt interfaces between a Si waveguide (WG) and a germanium photodiode, and in which a partially etched Si region is formed as the part of Si cavity etching for Ge growth. Ge is grown in this cavity. Some Si may remain under the Ge, as best seen in the cross-section through line A-A'. Silicon regions on either side of the Ge are respectively p-doped and n-doped to provide electrodes and/or contacts for conducting current out of the photodiode 100.

At the input interface of the photodiode 100, for example into the length of Ge of the photodiode 100, as indicated by the line 101, a significant portion of incident light is absorbed, as best seen in the graph of FIG. 1B. Indeed, almost no light is transmitted through the photodiode 100 and/or reaches an end of the photodiode 100, as indicated by the line 102. From the graph of FIG. 1B (where opposite ends of the photodiode 100 are indicated by corresponding lines 101, 102), which depicts simulated absorbed power along a propagation axis of the photodiode 100, it is understood that most light is absorbed in the first 2 microns of a 15 micron length of along the Ge of the photodiode. This excessive absorption of light in near the input to the photodiode 100 leads to the generation of surplus charge carriers input. These carriers, in turn, create an electric field opposing the P-N field within the photodiode, opposing the built-in electric field, and causing the photodiode's current response to deviate from linearity and drop in bandwidth response.

For example, with attention next directed to FIG. 1C, the effect of carrier screening on bandwidth is shown. In particular, FIG. 1C depicts bandwidth of the photodiode 100 as a function of input power, and it is apparent that the bandwidth may be limited to 40 GHz at low optical input power, and decrease significantly as input optical power increases. Put in another way, data encoded into the light carried by an input waveguide may be detected at a rate of 40 GHz (e.g., the bandwidth) at the photodiode 100, but a rate of detection of the light decreases significantly as input optical power increases. While bandwidth may be higher than 40 GHz at low optical power (e.g., up to about 70 GHz in some prior art photodiodes), the bandwidth still decreases with increasing optical power.

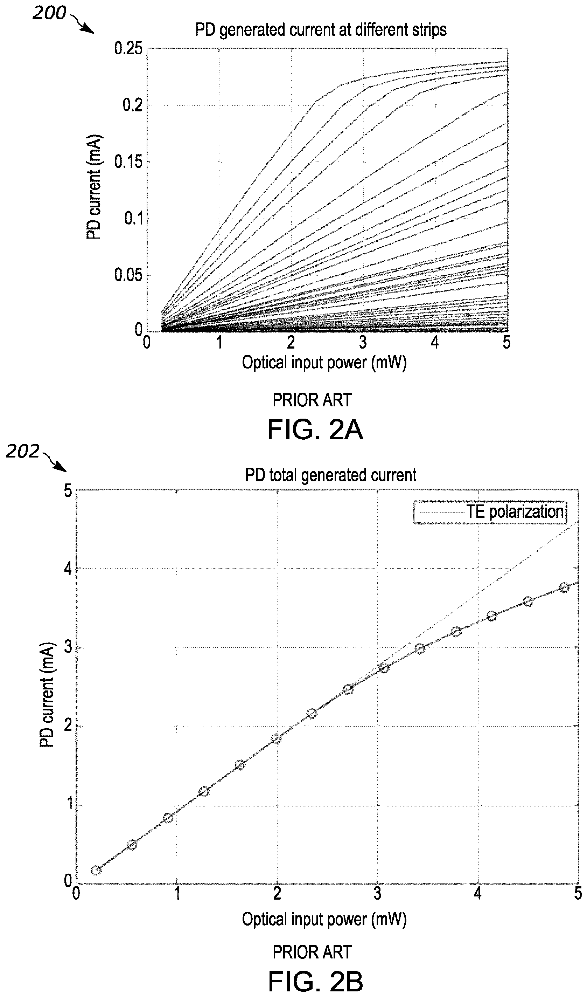

For example, FIG. 2A depicts a graph 200 showing a simulation of generated electric current of the photodiode 100 in sequential sections (strips) at increasing distances from the input of the photodiode 100, as a function of optical input power (e.g., power of a TE (Transverse Electric) mode of light entering the photodiode 100). The graph 200 illustrates that the photodiode current saturates at lower input powers in the regions close to the input section of the photodiode 100.

FIG. 2B depicts a graph 202 showing total photodiode current of a TE mode of the light input to the photodiode 100, as a function of optical input power, that may be obtained by summing the currents from all the segments of the photodiode 100 (e.g., and as depicted in the graph 200). From the graph 202, it is understood that nonlinearity in the photodiode current response begins at an input power level of approximately 3 mW. The straight line in the graph is shown merely to illustrate how total photodiode current might appear if linear, and to illustrate the deviation therefrom.

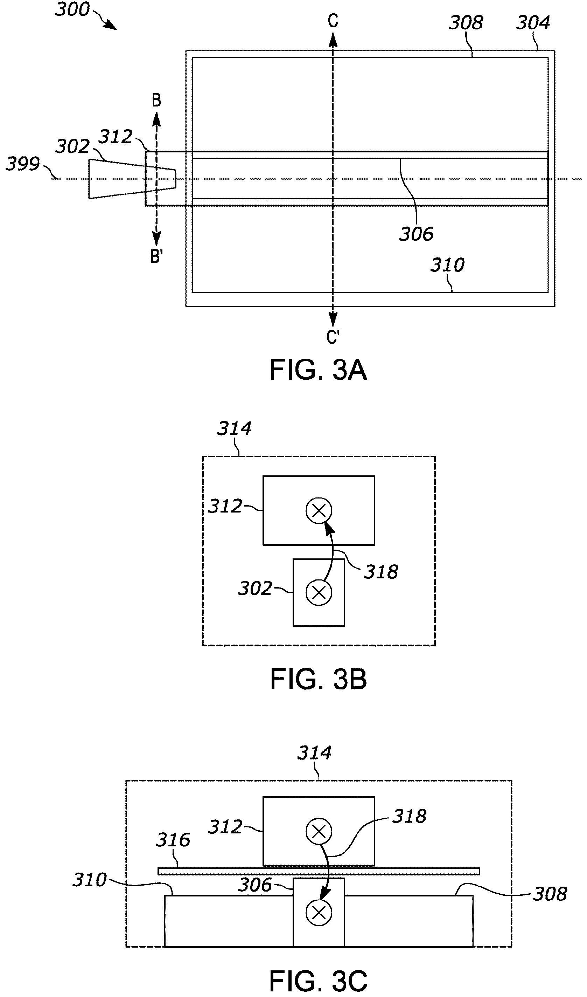

FIG. 3A depicts a schematic top view of a photodiode 300 with carrier screening mitigation. The photodiode 300 comprises an input waveguide 302 that provides light input to the photodiode 300. FIG. 3B depicts a cross-section through the photodiode 300 through a line B-B', and FIG. 3C depicts a cross-section through the photodiode 300 through a line C-C', but with the substrate 304 excluded for simplicity.

Components of the photodiode 300 are schematically shown in their entirety in FIG, 3A (e.g., as if they were transparent), merely to show relative positioning thereof. However, such components are understood to be formed in various layers, as best shown in the respective cross-sections of FIG. 3B and FIG. 3C.

The input waveguide 302, as depicted, is understood to be an end of a waveguide that is carrying light in an optical communication system that is detected by the photodiode 300.

The light wavelength carried by the input waveguide 302 may be in a range of 1 to 1.5 microns, and, in a specific example, may be about 1.3 microns, however light of any suitable wavelength is within the scope of the present specification.

As depicted, the photodiode 300 comprises a substrate 304 (e.g., such as a Si substrate), with may include a buried oxide (BOX) grown thereon (e.g., such as a silicon dioxide); however, the substrate 304 may include any suitable combination of layers and/or have any suitable structure. The photodiode 300 further comprises a length of photodiode material 306, such as Germanium (Ge), with a layer 308 of n-doped semiconductor (e.g., Si) and a layer 310 of p-doped semiconductor (e.g., Si) on either side of the length of photodiode material 306. The doped semiconductors act as contacts for the photodiode through which carriers formed by the light interacting with the photodiode material 306. Indeed the combination of the substrate 304, the length of photodiode material 306, and the layers 310, 308 may be similar to, and/or the same as, the photodiode 100.

However, the photodiode 300 further comprises an optical coupling waveguide 312, for example of polysilicon and/or silicon nitride (e.g., $Si_3N_4$), on the length of photodiode material 306, which may extend past the length of photodiode material 306 to over and/or adjacent to the input waveguide 302, as also seen in FIG. 3B. While in FIG. 3B the optical coupling waveguide 312 is "over" the input waveguide 302 (e.g., relative to the substrate 304), in other examples, the positions of the optical coupling waveguide 312 and the input waveguide 302 may be reversed (e.g., relative to the substrate 310), and/or the optical coupling waveguide 312 and the input waveguide 302 may be side-by-side (e.g., relative to the substrate 310), and/or the optical coupling waveguide 312 and the input waveguide 302 may be adjacent (e.g., relative to the substrate 310) in any suitable orientation for coupling light from the input waveguide 302 to the optical coupling waveguide 312.

The optical coupling waveguide 312 is understood to extend along the length of photodiode material 306, and may be about the same width, or wider, as the length of photodiode material 306. However, the optical coupling waveguide 312 may be any suitable width.

It is further understood from FIG. 3B and FIG. 3C that the photodiode 300, including the input waveguide 302, may be encased in a transparent layer and/or dielectric layer and/or multiple transparent layers and/or dielectric layers 314, including, but not limited to, Si dioxide ($SiO_2$), and the like. For simplicity, the transparent layer and/or dielectric layer and/or multiple transparent layers and/or dielectric layers 314 will be interchangeably referred to hereafter as the encasement layer 314 (which may include a plurality of layers). Furthermore, as depicted in FIG. 3C, the encasement layer 314 may extend (e.g., to the substrate 304) to encase the photodiode material 306, the layers 308, 310, the waveguide 312, and an optional thin sealing layer 316 (e.g., when present), as described hereafter.

In some examples, as best seen in FIG. 3C, the photodiode 300 may further comprise the thin sealing layer 316 between the length of photodiode material 306 and the optical coupling waveguide 312. The sealing layer 316 may be made of the same material as the optical coupling waveguide 312 (e.g., polysilicon and/or SiN), and/or may be made of multiple materials, but may be thin enough (e.g., less than about 50 nm thickness) that the sealing layer 316 does not significantly alter properties (e.g., power, mode shape, and the like, amongst other possibilities) of the light of the wavelength carried by the input waveguide 302.

Using particular examples of materials, at wavelengths carried by the input waveguide 302, when formed from Si, it is understood that the input waveguide 302 may have an index of refraction of about 3.5, the optical coupling waveguide 312 may have an index of refraction between about 3.5 (e.g., when formed from polysilicon) to about 2 (e.g., when formed from SiN), and the length of photodiode material 306, when formed from Ge, may have an index of refraction of about 4.2. Similarly, the sealing layer 316, when formed from SiN, may have an index of refraction of about 2, and the encasement layer 314, when formed from of $SiO_2$, may have an index of refraction of about 1.45. Furthermore, in particular examples, the optical coupling waveguide 312 may have a thickness in a range of about 200 nm to about 400 nm (and in particular examples about 300 nm), and the sealing layer 316 may have a thickness in a range of about 15 nm to about 40 nm (and in particular examples about 20 nm). However any suitable thicknesses are in the scope of the present specification.

Hence, it is understood that the input waveguide 302, and optical coupling waveguide 312 have indices of refraction higher than the surrounding encasement layer 314.

From FIG. 3A, it is understood that the input waveguide 302 is tapered at the end of the input waveguide 302 that overlaps with the optical coupling waveguide 312, and in particular tapered along a longitudinal axis 399 thereof (e.g., narrowing closer to the optical coupling waveguide 312). Furthermore while the taper of the input waveguide 302 is depicted as ending in a flat end, in other examples, the taper of the input waveguide 302 may end in a point.

Furthermore, the longitudinal axis 399 may be a common longitudinal axis of the input waveguide 302, the optical coupling waveguide 312 and the length of photodiode material 306.

Hence, the effective index of refraction of the input waveguide 302 (e.g., a combination of the index of refractions of the materials of the input waveguide 302 and the encasement layer 314) decreases along the longitudinal axis 399. Hence, as the input waveguide 302 and the overlapping optical coupling waveguide 312 are surrounded by the encasement layer 314 of lower index of refraction than both of the input waveguide 302, and the optical coupling waveguide 312, light 318 present in the input waveguide 302 transfers into the optical coupling waveguide 312 as the light 318 travels along the input waveguide 302. Furthermore, the light 318 travels along the length of the optical coupling waveguide 312, which is adjacent to the length of photodiode material 306, the light 318 transfers to the length of photodiode material 306 along the length of the optical coupling waveguide 312, rather than at an interface to the length of photodiode material 306, as in the photodiode 100. Put another way, as the length of photodiode material 306 generally has a higher index of refraction than the optical coupling waveguide 312, light in the optical coupling waveguide 312 is coupled into the length of photodiode material 306.

When the sealing layer 316 is present, the sealing layer 316 may act as an additional partial barrier to the light 318 transferring from the optical coupling waveguide 312 to the length of photodiode material 306, which may result in the light 318 transferring along a longer region along the optical coupling waveguide 312 to the length of photodiode material 306 than when the sealing layer 316 is not present. While the sealing layer 316 may be optional, when the sealing layer 316 is present, the sealing layer 316 may be taken into account when determining the degree of optical coupling between the optical coupling waveguide 312 and the length of photodiode material 306, and/or the lengths of the optical coupling waveguide 312 and the photodiode material 306 that are adjacent to each other. Indeed, the lengths of the optical coupling waveguide 312 and the photodiode material 306 may be selected heuristically so that no light 318 exits an end the optical coupling waveguide 312 opposite the input waveguide 302 and/or all of the light 318, and/or a substantial portion of the light 318, transfers from the optical coupling waveguide 312 to the photodiode material 306.

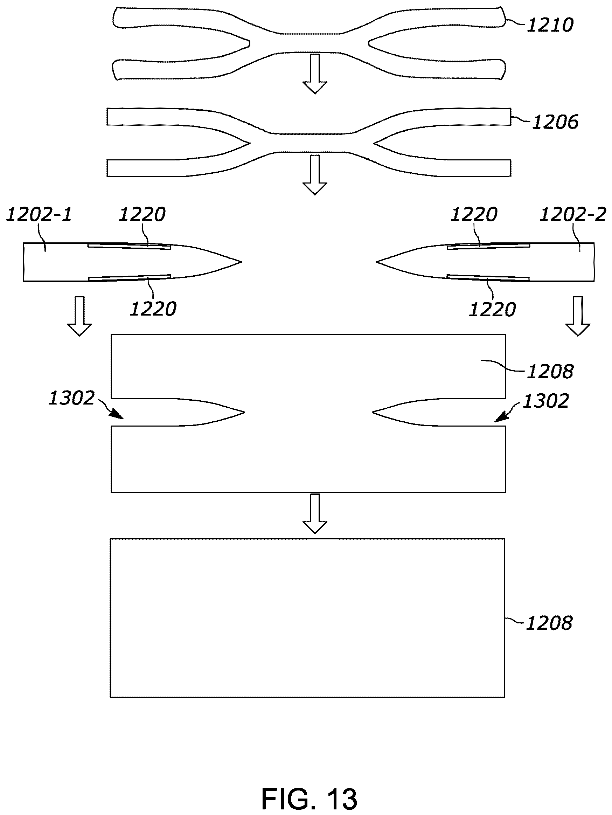

However, it is understood that optical coupling between the input waveguide 302 and the optical coupling waveguide 312 may occur in any suitable manner. For example, rather than a taper, the input waveguide 302 may have grooves etched therein (e.g., see the example of FIG. 13), which may be filled with transparent material (e.g., of the encasement layer 316) and the like, to achieve the aforementioned reduction in effective index of refraction along the longitudinal axis 399. However, any suitable structure optically coupling the input waveguide 302 and the optical coupling waveguide 312 is within the scope of present examples.

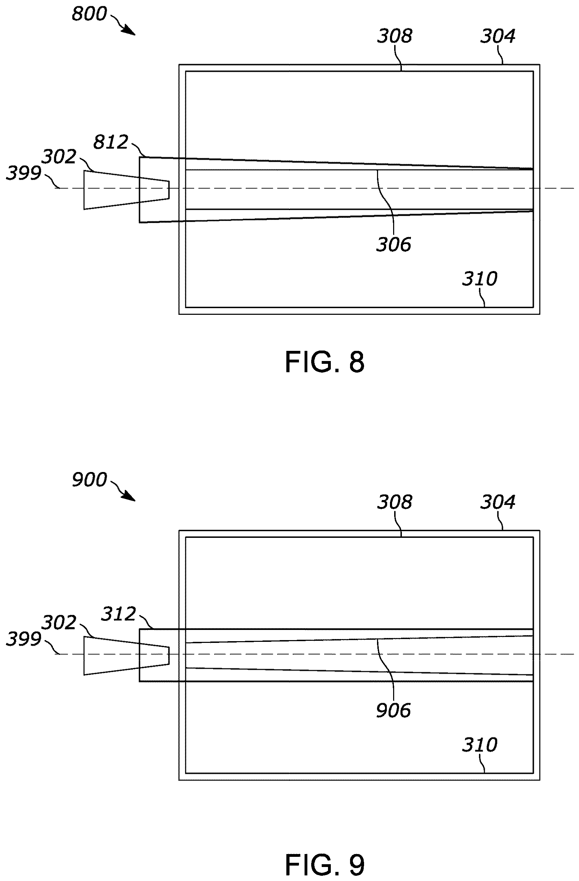

Similarly, optical coupling between the optical coupling waveguide 312 and the length of photodiode material 306 may occur in any suitable manner, using, for example tapering of the optical coupling waveguide 312 and/or the length of photodiode material 306, grooves in the optical coupling waveguide 312, and the like. However any suitable structure for optically coupling the optical coupling waveguide 312 and the length of photodiode material 306 is within the scope of present examples, including, but not limited to, certain examples depicted in FIG. 8 to FIG. 10.

Indeed, any suitable optical coupling structures between the input waveguide 302 and the optical coupling waveguide 312, and between the optical coupling waveguide 312 and the length of photodiode material 306, are within the scope of the present specification. Regardless, control of the transfer of light from the optical coupling waveguide 312 along the length of photodiode material 306 may occur, and a more uniform absorption of light along the length of the photodiode material 306 may result.

Furthermore, while particular materials are described with respect to the input waveguide 302, the length of photodiode material 306, optical coupling waveguide 312, and the layers 310, 308, 316 being of specific materials, it is understood that any suitable light carrying materials and/or photodiode materials are within the scope of the present specification.

With respect to the particular example of the optical coupling waveguide 312 being formed from poly Si and/or silicon nitride, and the length of photodiode material 306 being formed from Ge, as growing polysilicon on Ge may be challenging, in some examples the optical coupling waveguide 312 may be formed from silicon nitride.

Indeed, in general, it is understood that the photodiode 300 comprises: an input waveguide (e.g., the input waveguide 302), a photodiode component (e.g., the length of photodiode material 306 and the layers 310, 308), and an optical coupling waveguide (e.g., the optical coupling waveguide 312), the optical coupling waveguide adjacent a photodiode material (e.g., the length of photodiode material 306) of the photodiode component, at least partially along a length of the photodiode material, the input waveguide and the optical coupling waveguide optically coupled to each other at respective ends external to the photodiode component, such that the light from the input waveguide is transferred to the optical coupling waveguide, and the optical coupling waveguide and the photodiode material being optically coupled, such that the light from the optical coupling waveguide is transferred to the photodiode material at least partially along the length of the photodiode material (e.g., and not just at an end of the photodiode material that is closest to the waveguide).

Put another way, the light 318 from the input waveguide 302 may be first coupled into the optical coupling waveguide 312, and the light 318 coupled into the optical coupling waveguide 312 is then gradually coupled into the photodiode material 306, along an adjacent length of photodiode material 306.

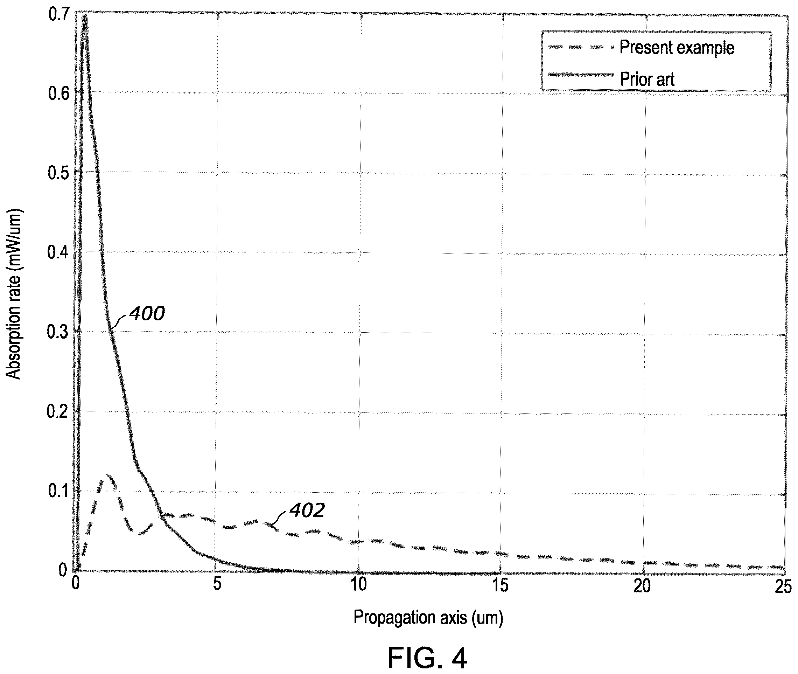

For example, attention is next directed to FIG. 4. which respectively depicts graphs 400, 402 of absorbed power along a longitudinal length of the photodiodes 100, 300. In the graph 400 of FIG. 4, the scale of the absorbed power along the y-axis ranges from 0 to 0.7 mW/micron, and the scale of the length along the x-axis ranges from 0 to 25 microns. From the graph 400 it is apparent that most of the light is absorbed in the first 2 microns of the photodiode 100.

In contrast, in the graph 402, the scale of the absorbed power ranges the y-axis is from 0 to 0.12 mW/micron, and the scale of the length along the x-axis ranges from 0 to 25 microns. Comparing the graphs 400, 402, it is apparent that absorption of the light occurs over a much longer length in the photodiode 300, as compared to the photodiode 100.

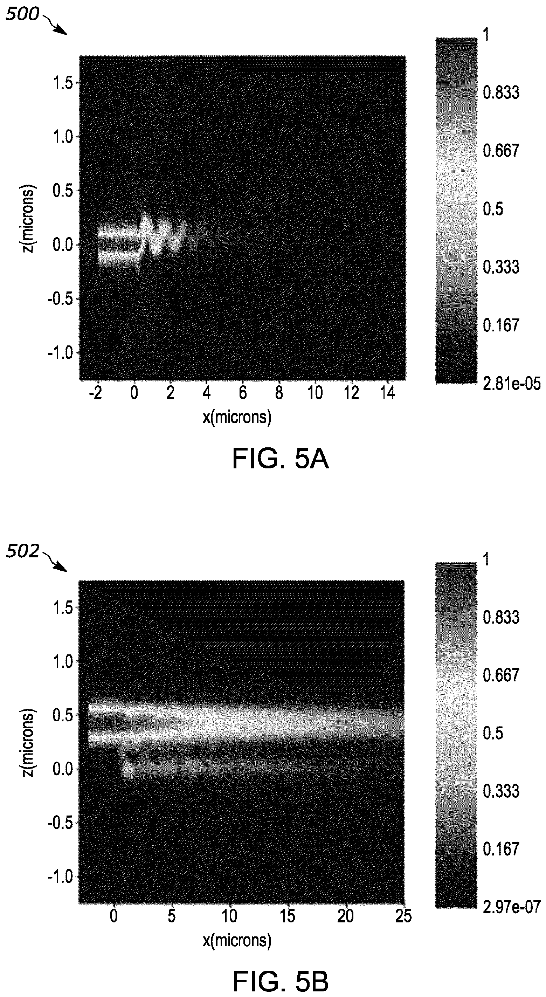

Similarly, attention is next directed to FIG. 5A and FIG. 5B, which respectively depict graphs 500, 502 of optical electric field as light (e.g., and/or a wave of light) propagates along a longitudinal length of the photodiodes 100, 300. Comparing FIG. 5A and FIG. 5B, it is apparent that the propagating light is quickly absorbed the first micron of the photodiode 100 (e.g., FIG. 5A), which leads to carrier screening, and which reduces quickly thereafter, whereas in the photodiode 300 (e.g., FIG. 5B), the electric field of the propagating light is spread out over a longer length before it is absorbed.

Hence, the graph 402, as compared to the graph 400, and the graph 502, as compared to the graph 500, clearly show that the structure of the photodiode 300 mitigates the carrier screening of the photodiode 100.

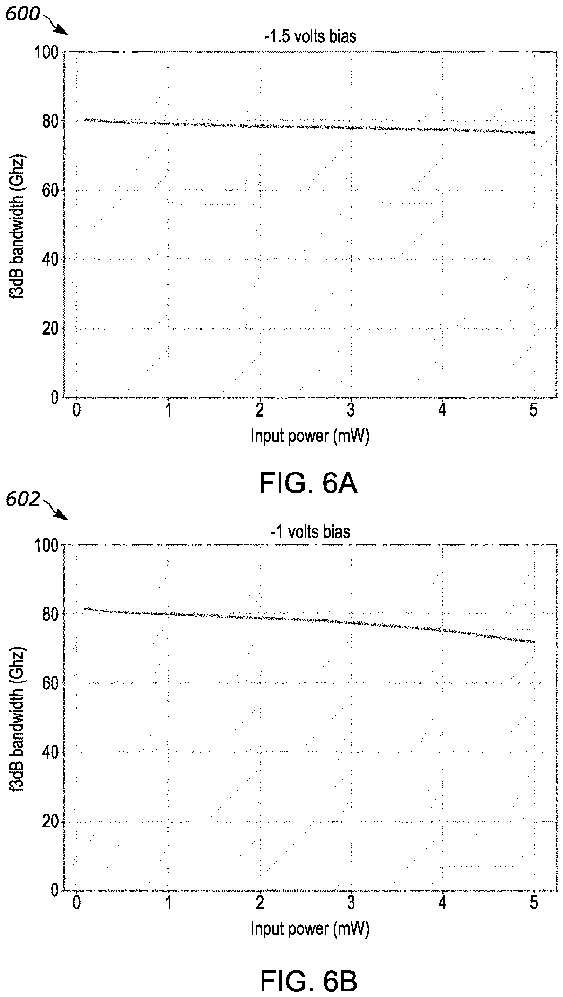

Attention is next directed to FIG. 6A and FIG. 6B, which depicts graphs 600, 602 showing bandwidth of the photodiode 300 as a function of input power, at a bias of - 1.5 volts and -1 volts respectively. From graphs 600, 602, it is apparent that the bandwidth may be about 80 GHz. Put another way, data encoded into the light carried by the input waveguide 302 may be detected at a rate of 80 GHz at the photodiode 300 regardless of the magnitude of optical input power. Comparing the graphs 600, 602 with FIG. 1C, it is apparent that the photodiode 300 may operate at much higher bandwidths than the photodiode 100 at high optical input powers, for example due to the carrier screening effect being present at the photodiode 100, and mitigated at the photodiode 300. Put another way, FIG. 1C illustrates that bandwidth of the photodiode 100 decreases as optical input power increases, whereas the graphs 600, 602 illustrate that the bandwidth of the photodiode 300 remains relatively constant as optical input power increases.

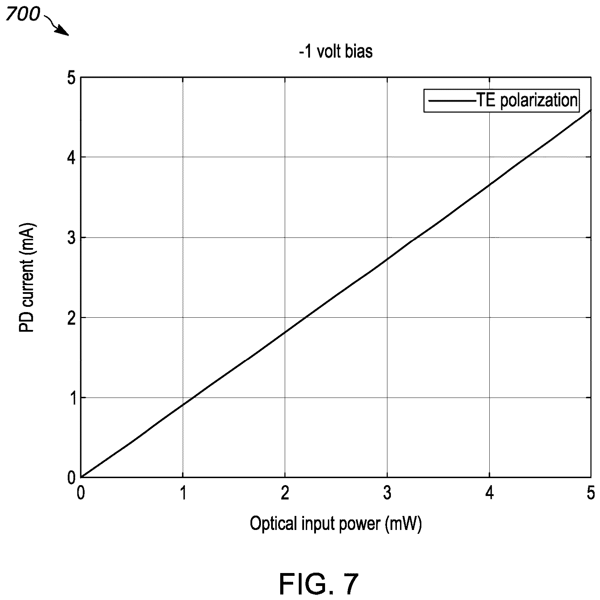

Attention is next directed to FIG. 7, which depicts a graph 700 showing a simulation of TE responsivity of the photodiode 300, shown as output current as a function of input power (e.g., of light carried by the input waveguide 302), at a bias of -1.5 V. The graph 700 clearly shows linearity of TE responsivity, and further shows a slope of about 0.9 mA/mW, which is close to a theoretical limit of 1.0566mA/mW for quantum efficiency. Such quantum efficiency may be determined according to Equation (1):

$$\eta = \frac{q\lambda}{hc} \ .... \text{Equation (1)}$$

In Equation (1), "q" is the charge of an electron, "c" is speed of light, "h" is the Planck constant, and "λ" is wavelength; in particular, wavelength may comprise the wavelength of light input to the photodiode 300 via the input waveguide 302 (e.g., 1.3 microns in some examples).

Alternatives to the photodiode 300 are within the scope of the present specification, including, but not limited to, alternatives in which one or both of the optical coupling waveguide 312 and the length of photodiode material 306, are adapted to promote light coupling as a function of length, as is next described.

For example, attention is next directed to FIG. 8, which depicts a photodiode 800 that is substantially similar to the photodiode 300, with like components having like numbers. However, at the photodiode 800, the optical coupling waveguide 312 has been replaced with a tapered optical coupling waveguide 812 (e.g., of poly-Si and/or SiN), that is otherwise similar to the optical coupling waveguide 312. The tapering of the optical coupling waveguide 812 comprise a reduction in width along the longitudinal axis 399 from the input waveguide 302 and/or along the length of photodiode material 306. Hence, the effective index of refraction of the tapered optical coupling waveguide 812 reduces along the longitudinal axis 299, such that coupling of light from the optical coupling waveguide 812 to the length of photodiode material 306 increases along the taper.

Attention is next directed to FIG. 9, which depicts a photodiode 900 that is substantially similar to the photodiode 300, with like components having like numbers. However, at the photodiode 800, the length of photodiode material 306 has been replaced with a tapered length of photodiode material 906, that is otherwise similar to the length of photodiode material 306. The tapering of the length of photodiode material 306 comprises an increase in width along a longitudinal axis from an end adjacent the input waveguide 302 and along the optical coupling waveguide 312. Hence, the effective index of refraction of the tapered length of photodiode material 906 increases along the longitudinal axis 399, such that coupling of light from the optical coupling waveguide 312 to the tapered length of photodiode material 906 increases along the taper.

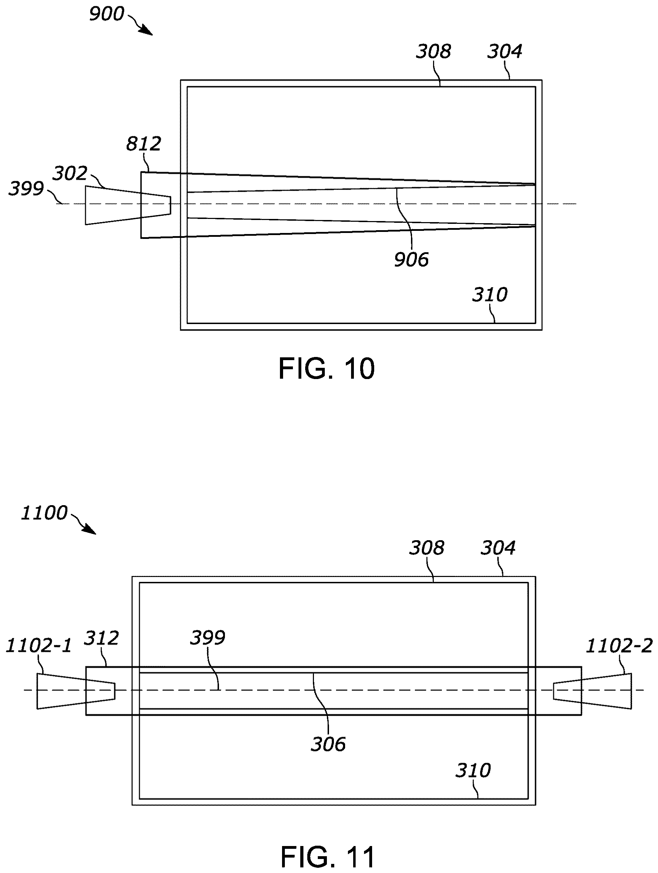

Attention is next directed to FIG. 10, which depicts a photodiode 1000 that is substantially similar to the photodiode 300, with like components having like numbers. However, at the photodiode 1000, the optical coupling waveguide 312 has been replaced with the tapered optical coupling waveguide 812, and the length of photodiode material 306 has been replaced with the tapered length of photodiode material 906. The tapering of the tapered optical coupling waveguide 812 and the tapered length of photodiode material 906 cause the respective effective indices of refraction of the tapered optical coupling waveguide 812 and the tapered length of photodiode material 906 to respectively decrease and increase along the longitudinal axis 399, such that coupling of light from the tapered optical coupling waveguide 812 to the tapered length of photodiode material 906 increases along the tapering.

Attention is next directed to FIG. 11, which depicts a photodiode 1100 that is substantially similar to the photodiode 300, with like components having like numbers. However, at the photodiode 1100, there are two waveguides 1102-1, 1102-2 at either end (e.g., opposite ends) of the optical coupling waveguide 312 (interchangeably referred to hereafter, collectively, as the input waveguides 1102 and, generically, as an input waveguide 1102). The input waveguides 1102 are substantially similar to the input waveguide 302, however, one input waveguide 1102-1 may carry light originally in a first polarization state (e.g., TE) and the other input waveguide 1102-2 may carry light originally in second polarization state (e.g., TM). For example light transmitted to the photodiode 1100 may carry two polarization states of an unknown ratio, and a polarization splitting component (not depicted) may split such light into the two polarization states, and convey such light of different polarization states to a respective input waveguide 1102. However, in some of these examples, light from one of the polarization states (e.g., TM) may be converted to the other polarization state (e.g., TE) using any suitable polarization converting component, not depicted, before being input to the photodiode 1100.

While the optical coupling waveguide 312 and the length of photodiode material 306 of the photodiode 1100 have a similar shape (e.g., non-tapered) as in the photodiode 300, one, or both, of the optical coupling waveguide 312 and the length of photodiode material 306 of the photodiode 1100 may be tapered in a manner that is respectively similar to the tapered optical coupling waveguide 812 and the tapered length of photodiode material 906.

Furthermore, a tapered optical coupling waveguide 812 of the photodiode 1000 may narrow from opposite ends of the photodiode 1100, along the longitudinal axis 399, to about a center of the photodiode 1100. Similarly, a tapered length of photodiode material 906 may conversely widen from opposite ends of the photodiode 1100, along the longitudinal axis 399, to about a center of the photodiode 1100.

Regardless of a shape of the optical coupling waveguide 312 and the length of photodiode material 306, respective distances from the respective input waveguides 1102 to a center of the of the photo diode 1100 may be selected such that light coupled into the optical coupling waveguide 312 is substantially transferred to, and absorbed by, the length of photodiode material 306 before the center. For example, absorption of the graph 402 and/or the electric field of the graph 502 may be used to select the length.

Furthermore, while the optical coupling waveguide 312 is depicted as a single length of material, the optical coupling waveguide 312 may be split into two sections that extend from opposite ends of the photodiode 1100 (e.g., along the longitudinal axis 399), and which may be separated at about the center of the photodiode 1100, with the aforementioned light coupling effects and associated carrier screening mitigation occurring at the opposite ends. Alternatively, or in addition, the length of photodiode material 306 may me similarly split into two sections.

The effect of coupling light into a photodiode along a length of the photodiode, to mitigate carrier screening, may be achieved with other architectures.

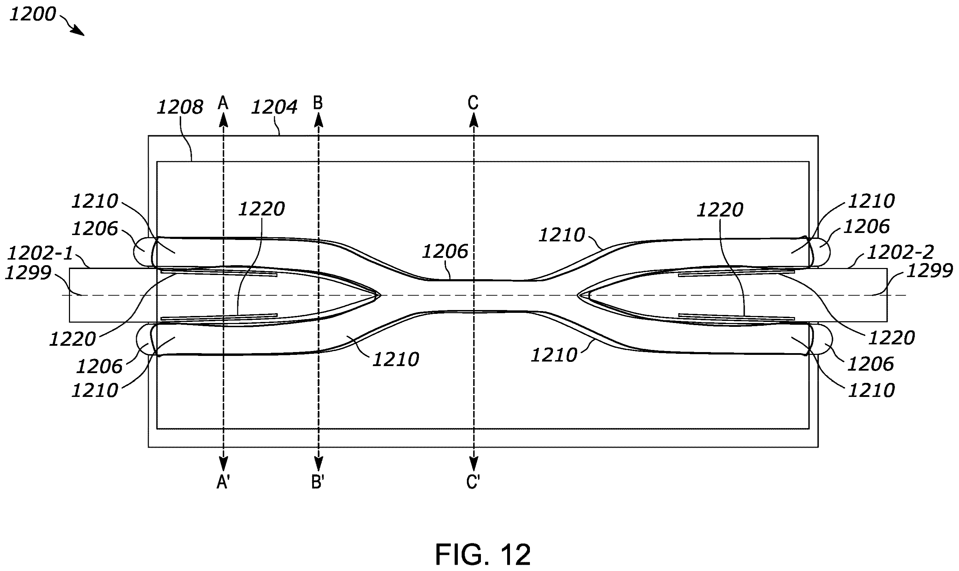

For example, attention is next directed to FIG. 12, which depicts a photodiode 1200 having components similar to the photodiode 300, with similar components having similar reference numbers as corresponding components of the photodiode 300, but in a "1200" series rather than a "300" series. Furthermore, the photodiode 1200 is a dual photodiode similar to the photodiode 1100, and hence has two input waveguides 1202-1, 1202-2 (interchangeably referred to hereafter, collectively, as the input waveguides 1202 and, generically, as an input waveguide 1202), similar to the input waveguides 1102. However the photodiode 1200 may alternatively have only one input waveguide 1202 (e.g., the photodiode 1200 may comprise only those components on one, or the other, side of a center line C-C').

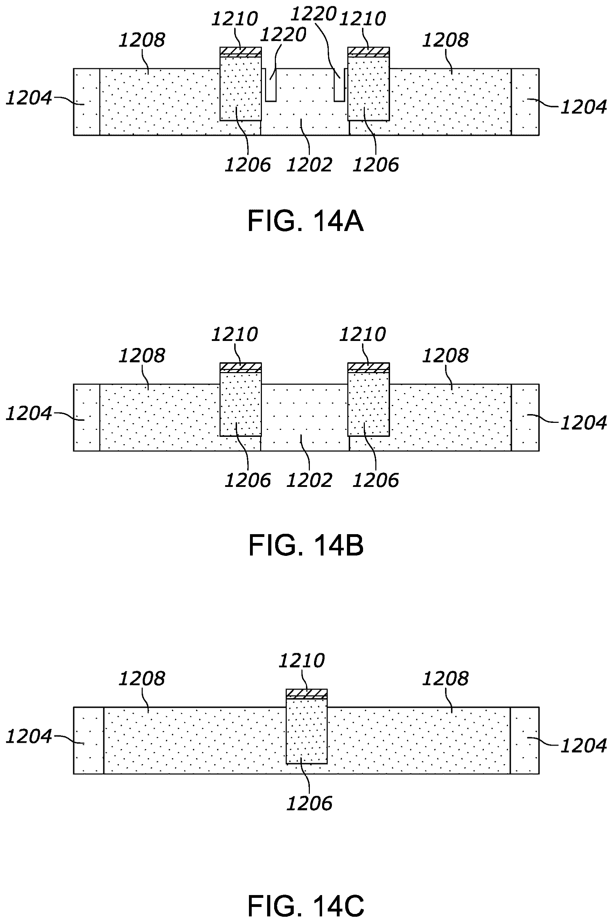

Furthermore, while for clarity the components of the photodiode 1200 are depicted as being transparent, such components are not necessarily transparent. Hence, for further clarity, FIG. 13 is provided, which depicts the components of the photodiode 1200 in an exploded view (with portions of an n-doped semiconductor shown and a photodiode material shown in layers to better show arches of respective horseshoe-shaped regions of the n-doped semiconductor and the photodiode material that accommodate the input waveguides 1202). FIG. 14A, FIG. 14B, and FIG. 14C respectively depict cross-sections of a portion of the photodiode 1200 through the lines A-A', B-B' and C-C' of FIG. 12, but without a lower portion of the substrate 1204 shown for simplicity. Nonetheless, the cross-sections depicted in FIG. 14A, FIG. 14B, and FIG. 14C show that the substrate 1204 may extend to either side of the other structures of the photodiode 1200, indicating that one or more of the other structures of the photodiode 1200 may be formed from doped regions of the substrate 1204 and/or via the substrate 1204 being etched and one or more of the other structures formed in the resulting etched regions. It is further understood that the input waveguides 1202 may be formed from a same material as the substrate 1204 and indeed the input waveguides 1202 and the substrate 1204 may be integral with each other, with the grooved regions 1220 ensuring that light that enters the input waveguides 1202 leaks into the photodiode material 1206 and not the substrate 1204.

Furthermore, components of the photodiode 1200 are schematically shown in their entirety in FIG. 12 (e.g., as if they were transparent), merely to show relative positioning thereof. However, such components are understood to be formed in various layers, as best shown in FIG. 13 and in the respective partial cross-sections of FIG. 14A, FIG. 14B, and FIG. 14C (for simplicity, a bottom portion of the substrate of the photodiode 1200 is not shown in the cross-sections).

As depicted, the photodiode 1200 comprises a pair of input waveguide 302 that provides light input to the photodiode 300.

As depicted, the photodiode 1200 comprises a substrate 1204, such as a Si substrate, which may include a BOX onto which a structure of photodiode material 1206, is grown. With reference to FIG. 13, and FIG. 14A, FIG.14B and FIG. 14C, the structure of photodiode material 1206 may have regions (e.g., horseshoe-shaped regions) that are adjacent to the input waveguides 1202 at least one respective side of the input waveguides 1202, such that light from the input waveguides 1202 is coupled into the structure of photodiode material 1206. The horseshoe regions of the structure of photodiode material 1206 may be joined via a straight and/or linear region (e.g., along a longitudinal axis 1299) at about the center of the photodiode 1200, and/or may be split into two sections.

Furthermore, at least a portion of the sides of the input waveguides 1202 that are adjacent the structure of photodiode material 1206 may have grooved regions 1220 (e.g., which may be filled, and the like, and are best seen in cross-section in FIG. 14A) to reduce the effective index of refraction of the input waveguides 1202, and thereby promote transfer of light from the input waveguides 1202 into the structure of photodiode material 1206; similarly ends of the input waveguides 1202 are tapered for similar reasons. Indeed, the input waveguides 1202 may have any suitable structure to promote transfer of light from the input waveguides 1202 into the structure of photodiode material 1206 along a length of the input waveguides 1202 (e.g., rather than at one end only).

Indeed, put another way, with respect to one input waveguide 1202, the structure of photodiode material 1206 may include a horseshoe-shaped region, and the input waveguide 1202 may be tapered to fit between arms of the horseshoe-shaped region of the structure of the photodiode material 1206. Furthermore, the one or more grooved regions 1220 may comprise respective grooved regions on opposite sides of the input waveguide 1202; furthermore the one or more grooved regions 1220 are understood to be adjacent respective arms of the horseshoe-shaped region of the structure of photodiode material 1206.

As best seen in FIG. 13, and FIG. 14A, FIG.14B and FIG. 14C, the photodiode 1200 further comprises a layer 1208 of n-doped semiconductor (e.g., Si) adjacent the structure of photodiode material 1206 on a side opposite the input waveguides 1202, and "under" the structure of photodiode material 1206 (e.g., adjacent the structure of photodiode material 1206 at one or more sides, other than a side of the structure of photodiode material 1206 that is adjacent the input waveguides 1202). As best been in FIG. 13, similar to the layer 1206, the layer 1208 of n-doped semiconductor includes openings 1302 (e.g., horseshoe-shaped regions) to accommodate the input waveguides 1202 and the structure of photodiode material 1206.

As depicted, the photodiode 1200 further comprises a layer 1210 of p-doping (e.g., Si) on the surface of the structure of photodiode material 1206, which may hence have a same and/or similar shape as the structure of photodiode material 1206. Indeed, the layers 1206, 1208 may be similarly shaped as the layer 1208 is understood to be on the layer 1206, and hence both layers 1206, 1208 are shaped to accommodate the tapered shape of the input waveguides 1202, as is the layer 1210.

However, the doping polarity of the layers 1208, 1210 may be swapped, for example depending on capabilities of a foundry manufacturing the photodiode 1200, such that the layer 1208 comprises p-doped semiconductor and the layer 1210 comprises n-doping.

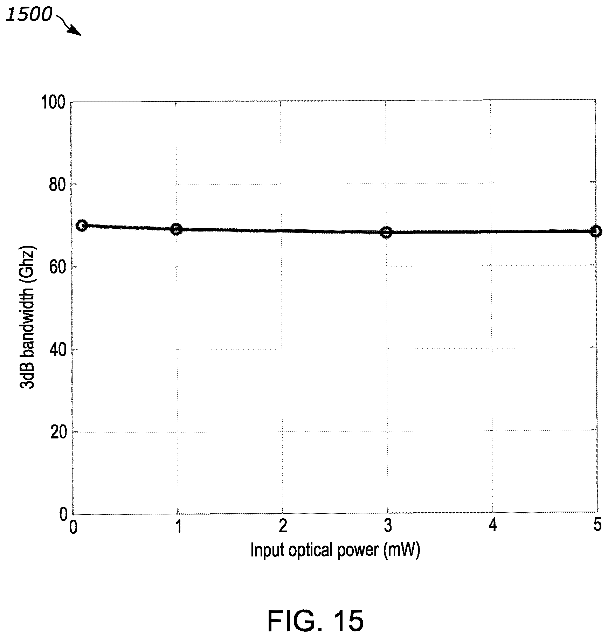

In operation, light from the input waveguides 1202 is optically coupled into the photodiode material 1206 along adjacent sides thereof, which excites the photodiode material 1206 causing current to flow. As the optically coupling occurs along a length of the input waveguides 1202 and the photodiode material 1206, and not only at one end of the photodiode material 1206 (e.g., as in the photodiode 100) carrier screening mitigation occurs. For example, attention is directed to FIG. 15, showing a graph 1500 of bandwidth vs input power (e.g., at a bias of -1.5 V) for the photodiode 1200. From graph 1500, it is apparent that bandwidth for the photodiode 1200 is at about 70 GHz across a range of input powers.

Indeed, in general, it is understood that the photodiode 1200 comprises: an input waveguide (e.g., an input waveguide 1202), a photodiode component (e.g., the structure of photodiode material 1206 and the layers 1210, 1208), input waveguide and a photodiode material of the photodiode component arranged adjacent to each other at least partially along a length of the photodiode material, such that the light from the input waveguide is transferred to the photodiode material at least partially along the length of the photodiode material (e.g., and not just at an end of the photodiode material that is closest to the waveguide). As such, control of the transfer of light from the input waveguide 1202 to photodiode material 1206 may occur, and a more uniform absorption of light along the longitudinal length of the photodiode material 1206 may result.

Indeed, the structure of the photodiode 1200 may be adapted so that optical coupling between an input waveguide 1202 and the photodiode material 1206 along only one side of the input waveguide 1202. In such examples, the photodiode material 1206 may not have a horseshoe-shaped region; rather the photodiode material 1206 may be along only one side of an input waveguide 1202 (e.g., that includes the one or more grooves 1220).

Furthermore, as light travels further into an input waveguide 1202, intensity of the light decreases, and indeed a length and/or shape of an input waveguide 1202 may be selected to control the intensity of the light such that, when arms of the horseshoe-shaped region of the photodiode material 1206 join, and a linear region of the photodiode material 2106 is provided, the intensity of the light may be sufficiently low to not cause carrier screening. As such, the linear region of the photodiode material 2106 may absorb the remainder of the light without carrier screening effects. Such a structure may hence shorten an overall length of the photodiode 1200.

Other optical coupling structures, for coupling light between an input waveguide and a structure of a photodiode material, for example along a length of a structure of photodiode material, are within the scope of the present specification. For example, while the grooves 1220 cause a reduction of the effective index of refraction of the input waveguides 1202, such grooves 1220 may be challenging to manufacture as they may be etched after fabrication of the photodiode material 1206 (e.g., without the grooves 1220).

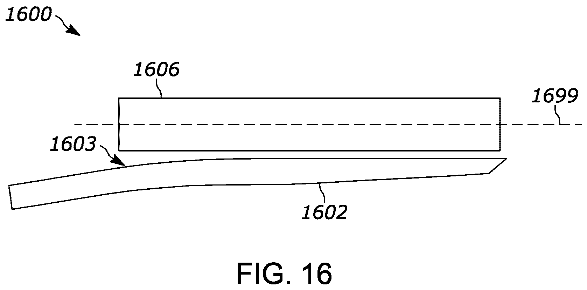

For example, attention is next directed to FIG. 16, which depicts an alternative optical coupling structure 1600 for optical coupling between an input waveguide 1602 and a structure of a photodiode material 1606, and which may be incorporated into the photodiode 1200, the input waveguide 1602 and the photodiode material 1606 replacing an input waveguide 1202 and the photodiode material 1206, but with the remaining components adapted to shapes of the input waveguide 1602 and the photodiode material 1606.

For example, as depicted, an input waveguide 1602 is adjacent to a length of the structure of photodiode material 1606 (e.g., which may have a similar shape as the length of photodiode material 306), but a gap 1603 between the input waveguide 1602 and a structure of photodiode material 1606 may decrease along a longitudinal axis 1699 of the structure of photodiode material 1606, such that, the closer the input waveguide 1602 gets to the structure of photodiode material 1606 (e.g., the deeper into the optical coupling structure 1600), the more light is coupled from the input waveguide 1602 into the structure of photodiode material 1606. The lengths of the input waveguide 1602 and the structure of photodiode material 1606 may be selected such that all, and/or a substantial portion, of light carried by the input waveguide 1602 is coupled into the structure of photodiode material 1606.

While layers of n-doped and p-doped material, corresponding to the layers 1208, 1210, are not depicted, they may nonetheless be present, but adapted for the shapes of the input waveguide 1602 and the structure of photodiode material 1606.

In alternative examples, the alternative optical coupling structure 1600 may adapted to include both the depicted structure, and a mirror image thereof.

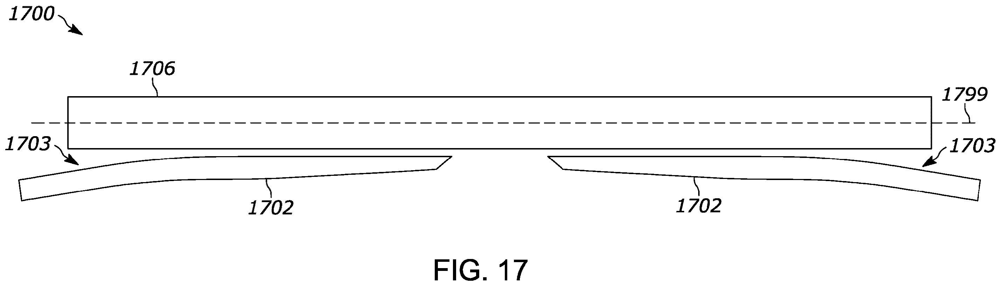

For example, attention is next directed to FIG. 17, an alternative optical coupling structure 1700 for optical coupling between two input waveguides 1702 and a structure of photodiode material 1706. The alternative optical coupling structure 1700 is similar to the alternative optical coupling structure 1600, but includes two input waveguides 1702 adjacent along a same side as the structure of photodiode material 1706, but from opposite ends, with respective gaps 1703, between the two input waveguides 1702 and the structure of photodiode material 1706, decreasing along a longitudinal axis 1799, but from opposite directions. The length of the structure of photodiode material 1706 of the alternative optical coupling structure 1700 may be about double a respective length of the structure of photodiode material 1606 of the optical coupling structure 1600. In general, light may be input to both input waveguides 1702 from opposite ends of the alternative optical coupling structure 1700, and with lengths of the input waveguide 1702 and the structure of photodiode material 1706 selected such that all, and/or a substantial portion, of the light is optically coupled into the structure of photodiode material 1706.

Again, while layers of n-doped and p-doped material, corresponding to the layers 1208, 1210, are not depicted, they may nonetheless be present, but adapted for the shapes of the input waveguide 1702 and the structure of photodiode material 1706.

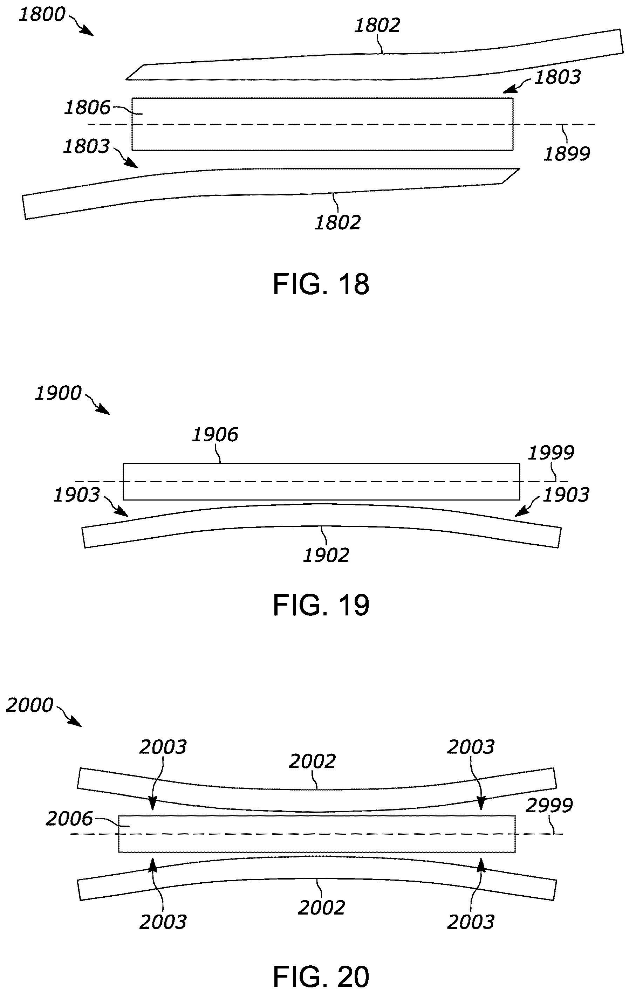

Attention is next directed to FIG. 18, which depicts yet another alternative optical coupling structure 1800, that is similar to the alternative optical coupling structure 1700, but with two input waveguides 1802 adjacent along opposite sides of the structure of photodiode material 1806, and with respective gaps 1803 between the two input waveguides 1802 and the structure of photodiode material 1806 decreasing along the longitudinal axis 1899, but from opposite directions, however, in other examples, the two input waveguides 1802 may be 1802 adjacent along opposite sides of the structure of photodiode material 1806, but with respective gaps 1803 between the two input waveguides 1802 and the structure of photodiode material 1806 decreasing along a longitudinal axis 1899, but from a same direction (e.g., a mirror image of the alternative optical coupling structure 1800). In general, light may be input to both input waveguides 1802 from opposite ends of the alternative optical coupling structure 1800, and with lengths of the input waveguides 1802 and the structure of photodiode material 1806 selected such that all, and/or a substantial portion, of the light is optically coupled into the structure of photodiode material 1806.

Again, while layers of n-doped and p-doped material, corresponding to the layers 1208, 1210, are not depicted, they may nonetheless be present, but adapted for the shapes of the input waveguide 1802 and the structure of photodiode material 1806.

Attention is next directed to FIG. 19, which depicts yet another alternative optical coupling structure 1900, and includes an input waveguide 1902 adjacent a side of a structure of photodiode material 1906, and with a gap 1903 therebetween decreasing, and then increasing along a longitudinal axis 1999 of the structure of photodiode material 1906, with the input waveguide 1902 being closest to the structure of photodiode material 1906 at about a center of the structure of photodiode material 1906. Put another way, the gap 1903 may be narrowest at about a center of the structure of photodiode material 1906, however the gap 1903 may be about constant along a portion of the structure of photodiode material 1906; indeed, a configuration of the gap 1903 may be heuristically selected to control optical coupling between the input waveguide 1902 and the structure of photodiode material 1906 in any suitable manner. In general, light may be input to the input waveguide 1902 from opposite ends thereof, and with lengths of the input waveguide 1902 and the structure of photodiode material 1906 selected such that all, and/or a substantial portion, of the light is optically coupled into the structure of photodiode material 1906.

Again, while layers of n-doped and p-doped material, corresponding to the layers 1208, 1210, are not depicted, they may nonetheless be present, but adapted for the shapes of the input waveguide 1902 and the structure of photodiode material 1906.

Attention is next directed to FIG. 20, which depicts yet another alternative optical coupling structure 2000, and includes two input waveguides 2002 adjacent opposite sides of a structure of photodiode material 2006, and which are both substantially similar to the input waveguide 1902 of the alternative optical coupling structure 1900, and form respective gaps 2003 therebetween, the respective gaps 2003 decreasing, and then increasing along a longitudinal axis 2099 of the structure of photodiode material 1206, with an input waveguide 2002 being closest to the structure of photodiode material 2006 at about a center of the structure of photodiode material 2006. Put another way, the gaps 2003 may be narrowest at about a center of the structure of photodiode material 2006; however the gaps 2003 may be about constant along a portion of the structure of photodiode material 2006; indeed, a configuration of the gaps 2003 may be heuristically selected to control optical coupling between the input waveguides 2002 and the structure of photodiode material 2006 in any suitable manner. In this example, light may be input to both input waveguide 2002 from opposite ends thereof, and with lengths of the input waveguides 2002 and the structure of photodiode material 2006 selected such that all, and/or a substantial portion, of the light is optically coupled into the structure of photodiode material 2006.

Again, while layers of n-doped and p-doped material, corresponding to the layers 1208, 1210, are not depicted, they may nonetheless be present, but adapted for the shapes of the input waveguide 2002 and the structure of photodiode material 2006.

It is further understood that in the photodiode 1200, and the alternative optical structures 1600, 1700, 1800, 1900, 2000, respective input waveguides 1202, 1602, 1702, 1802, 1902, 2002 are coplanar with a respective structure of photodiode material 1206, 1606, 1706, 1806, 1906, 2006.

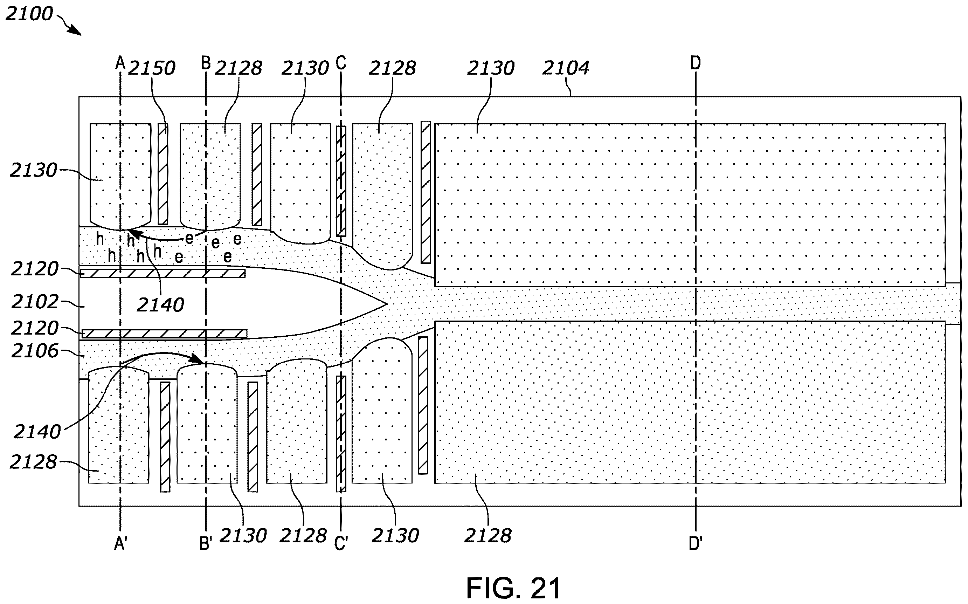

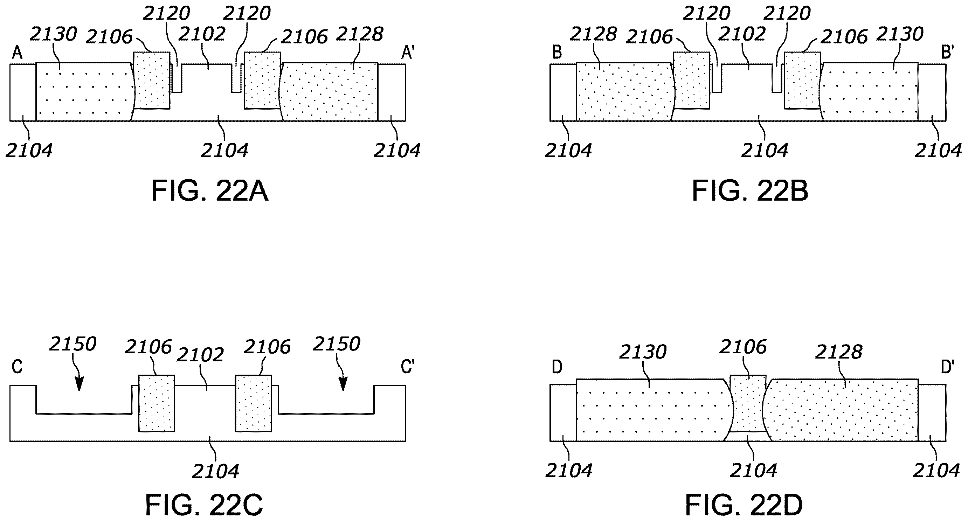

Attention is next directed to FIG. 21, which depicts another photodiode 2100, and FIG. 22A, FIG. 22B, FIG. 22C, and FIG. 22D, which respectively depict partial cross-sections through the lines A-A', B-B' and C-C' of FIG. 21. The photodiode 2100 may also provide carrier screening mitigation.

In particular, the structure of the photodiode 2100 is similar to the photodiode 1200, and includes an input waveguide 2102, a substate 2104 and a photodiode region 2106, that are substantially similar (e.g., in shape and function) to an input waveguide 1202, the substate 2104 (e.g., Silicon) and a photodiode region 1206 of the photodiode 1200. Furthermore, the input waveguide 2102 includes grooves 2120 similar to the grooves 1220.

However, rather than a p-doped semiconductor region on top of the photodiode material 2106 (e.g., Ge), n-doped semiconductor regions 2128 and p-doped semiconductor regions 2130 (e.g., n-doped and p-doped Silicon, respectively) alternate and/or are interleaved along the horseshoe-shaped region of the photodiode material 2106, on respective sides of the photodiode material 2106 opposite that of the input waveguide 2102.

Light enters the photodiode 2100 and gets gradually absorbed from the side by the photodiode material 1206 on each side. Similar to the photodiode 1200, the grooves 2120 may be used to control and limit the absorption of light along the photodiode material 2106.

It is understood that an electric field 2140 may be formed between neighboring interleaved n-doped semiconductor regions 2128 and the p-doped semiconductor regions 2130, which may sweep the electron carriers (e.g., "e" in FIG. 21) and hole carriers (e.g., "h" in FIG. 21) generated in the photodiode material respectively toward the n-doped semiconductor regions 2128 and p-doped semiconductor regions 2130. While only one electric field 2140 is depicted, it is understood that such electric fields 2140 are formed between pairs of neighboring interleaved n-doped semiconductor regions 2128 and the p-doped semiconductor regions 2130.

As depicted, shallow etch, or full etch, regions 2150 (e.g., grooves) may be provided between the n-doped semiconductor regions 2128 and the p-doped semiconductor regions 2130, and the etched regions 2140 may isolate the p-doped and n-doped regions to prevent current and charge build-up between neighboring doped regions 2128, 2130. While only one etch region 2150 is labelled for simplicity, it is understood that a respect etch region 2150 is depicted between each pair of doped regions 2128, 2140.

It is further understood that, outside of the horseshoe-region of the photodiode material 2106, and/or in a linear region of the photodiode material 2106, doped regions 2128, 2130 are on respective sides of the photodiode material 2106, for example to conduct any remaining carriers out of the photodiode material 2106.

Put another way, as light travels further into the input waveguide 2102, intensity of the light decreases, and indeed a length and/or shape of the input waveguide 2102 may be selected to control the intensity of the light such that, when arms of the horseshoe-shaped region of the photodiode material 2106 join, and a linear region of the photodiode material 2106 is provided, the intensity of the light may be sufficiently low to not cause carrier screening. As such, the linear region of the photodiode material 2106 may absorb the remainder of the light without carrier screening effects. Such a structure may hence shorten an overall length of the photodiode 2100.

It is further understood that shapes of the doped regions 2128, 2130 may be adapted to extend to the photodiode material 2106. For example, as the arms of the horseshoe-shaped regions of the photodiode material 2106 get closer together (e.g., towards the linear region of the photodiode material 2106), doped regions 2128, 2130 may lengthen relative to doped regions 2128, 2130 closer to an input to the input waveguide 2102, so that the doped regions 2128, 2130 remain adjacent to the photodiode material 2106. Such lengthening may occur so that ends of the doped regions 2128, 2130 that are distal from the photodiode material 2106 may be about aligned, which may simplify electrical connections thereto.

Further, the cross-sections depicted in FIG. 22A, FIG. 22B, FIG. 22C and FIG. 22D show that the substrate 2104 may extend to either side of the other structures of the photodiode 2100, indicating that one or more of the other structures of the photodiode 2100 may be formed from doped regions of the substrate 2104 and/or via the substrate 2104 being etched and one or more of the other structures formed in the resulting etched regions. It is further understood that the input waveguides 2102 may be formed from a same material as the substrate 2104 and indeed, as depicted, the input waveguides 2102 and the substrate 2104 may be integral with each other, with the grooved regions 2120 ensuring that light that enters the input waveguides 2102 leaks into the photodiode material 2106 and not the substrate 2104.

It is understood that instance of the term "configured to", such as "a computing device configured to...", "a processor configured to...", "a controller configured to...", and the like, may be understood to include a feature of a computer-readable storage medium having stored thereon program instructions that, when executed by a computing device and/or a processor and/or a controller, and the like, may cause the computing device and/or the processor and/or the controller to perform a set of operations which may comprise the features that the computing device and/or the processor and/or the controller, and the like, are configured to implement. Hence, the term "configured to" is understood not to be unduly limiting to means plus function interpretations, and the like.

Furthermore, descriptions of one processor and/or controller and/or device and/or engine, and the like, configured to perform certain functionality is understood to include, but is not limited to, more than one processor and/or more than one controller and/or more than one device and/or more than one engine, and the like performing such functionality.

It is understood that for the purpose of this specification, language of "at least one of X, Y, and Z" and "one or more of X, Y and Z" may be construed as X only, Y only, Z only, or any combination of two or more items X, Y, and Z (e.g., XYZ, XY, YZ, XZ, and the like). Similar logic may be applied for two or more items in any occurrence of "at least one..." and "one or more..." language.

The terms "about", "substantially", "essentially", "approximately", and the like, are defined as being "close to", for example as understood by persons of skill in the art. In some examples, the terms are understood to be "within 10%," in other examples, "within 5%", in yet further examples, "within 1%", and in yet further examples "within 0.5%".

Persons skilled in the art will appreciate that there are yet more alternative examples and modifications possible, and that the above examples are only illustrations of one or more examples. The scope, therefore, is only to be limited by the claims appended hereto.

## Claims

1. A photodiode comprising:

an input waveguide;
a photodiode component;
and an optical coupling waveguide,
wherein the input waveguide and the optical coupling waveguide are optically coupled to each other at respective ends external to the photodiode component,
wherein the optical coupling waveguide is adjacent a photodiode material of the photodiode component, at least partially along a length of the photodiode material, and
wherein the optical coupling waveguide and the photodiode material are optically coupled at least partially along the length of the photodiode material.

2. The photodiode of claim 1, wherein one or more of:

the input waveguide and the photodiode material of the photodiode material do not overlap;
the input waveguide is not optically coupled to the photodiode material of the photodiode material; and
the input waveguide does not input light to the photodiode material of the photodiode material.

3. The photodiode of claim 1, wherein the photodiode material has a higher index of refraction than the optical coupling waveguide.

4. The photodiode of claim 1, wherein one or more of:

the input waveguide is tapered, narrowing along a longitudinal axis, and along the optical coupling waveguide; and
the input waveguide has an effective index of refraction that decreases along the longitudinal axis, and along the optical coupling waveguide.

5. The photodiode of claim 1, wherein one or more of:

the optical coupling waveguide is tapered, narrowing along a longitudinal axis, and along the photodiode material; and
the optical coupling waveguide has an effective index of refraction that decreases along the longitudinal axis, and along the photodiode material.

6. The photodiode of claim 1, wherein one or more of:

the photodiode material is tapered, widening along a longitudinal axis, and along the optical coupling waveguide; and
the photodiode material has an effective index of refraction that increases along the longitudinal axis, and along the optical coupling waveguide.

7. The photodiode of claim 1, wherein one or more of:

   the input waveguide is tapered, narrowing along a longitudinal axis, and along the optical coupling waveguide;
   the optical coupling waveguide is tapered, narrowing along the longitudinal axis, and along the photodiode material; and
   the photodiode material is tapered, widening along the longitudinal axis, and along the optical coupling waveguide.

8. The photodiode of claim 1, wherein one or more of:

   the input waveguide has an effective index of refraction that decreases along a longitudinal axis, and along the optical coupling waveguide;
   the optical coupling waveguide has a respective effective index of refraction that decreases along the longitudinal axis, and along the photodiode material; and
   the photodiode material has a respective further effective index of refraction that increases along the longitudinal axis, and along the optical coupling waveguide.

9. The photodiode of claim 1, further comprising a substate, wherein the optical coupling waveguide is over the photodiode material, relative to the substrate, and one of:

   over the input waveguide, relative to the substrate;
   below the input waveguide, relative to the substrate; and,
   side-by-side with the input waveguide, relative to the substrate.

10. The photodiode of claim 1, further comprising:
   a sealing layer between a length of the photodiode material and the optical coupling waveguide, the sealing layer configured to not alter properties of light of a wavelength carried by the input waveguide .

11. A photodiode comprising:

   an input waveguide; and
   a photodiode component,
   wherein the input waveguide is adjacent a structure of a photodiode material of the photodiode component, at least partially along a length of the structure of the photodiode material, and wherein a gap between the input waveguide and the structure of the photodiode material decreases along a longitudinal axis of the structure, such that, as the gap narrows, more light is coupled from the input waveguide into the structure of the photodiode material.

12. The photodiode of claim 11, further comprising:

   an additional input waveguide adjacent the structure of the photodiode material, the additional input waveguide located at an end of the structure of the photodiode material opposite the input waveguide, the additional input waveguide located at least partially along the length of the structure of the photodiode material, and wherein a respective gap between the additional input waveguide and the structure of the photodiode material decreases along the longitudinal axis of the structure of the photodiode material, such that, as the respective gap narrows, more respective light is coupled from the additional input waveguide into the structure of the photodiode material.

13. The photodiode of claim 11, further comprising:

   an additional input waveguide adjacent the structure of the photodiode material, the additional input waveguide located at a side of the structure of the photodiode material opposite the input waveguide, the additional input waveguide located at least partially along the length of the structure of the photodiode material, and wherein a respective gap between the additional input waveguide and the structure of the photodiode material decreases along the longitudinal axis of the structure of the photodiode material, such that, as the respective gap narrows, more light is coupled from the additional input waveguide into the structure of the photodiode material.

14. The photodiode of claim 11, wherein the gap is narrowest at about a center of the structure of the photodiode material, and wherein the gap, thereafter, increases along the longitudinal axis.

15. The photodiode of claim 14, further comprising:

   an additional input waveguide adjacent the structure of the photodiode material, the additional input waveguide located at a side of the structure of the photodiode material opposite the input waveguide, the additional input waveguide located at least partially along the length of the structure of the photodiode material, and wherein a respective gap between the additional input waveguide and the structure of the photodiode material decreases along the longitudinal axis of the structure of the photodiode material, such that, as the respective gap narrows, more light is coupled from the additional input waveguide into the structure of the photodiode material,

wherein the respective gap is narrowest at about the center of the structure of the photodiode material, and

wherein the respective gap, thereafter, increases along the longitudinal axis.

16. A photodiode comprising:

an input waveguide; and
a structure of photodiode material,
wherein the input waveguide and the structure of photodiode material are optically coupled to each other at least partially along a length of the structure of photodiode material,
wherein the input waveguide includes one or more grooved regions to reduce an effective index of refraction of the input waveguide adjacent the structure of photodiode material, thereby promoting transfer of light from the input waveguide into the structure of the photodiode material.

17. The photodiode of claim 16, wherein the structure of photodiode material includes a horseshoe-shaped region,

wherein the input waveguide is tapered to fit between arms of the horseshoe-shaped region of the structure of the photodiode material, and
wherein the one or more grooved regions comprise respective grooved regions on opposite sides of the input waveguide, and adjacent respective arms of the horseshoe-shaped region of the structure of photodiode material.

18. The photodiode of claim 16, wherein the one or more grooved regions are filled with one or more of dielectric material and transparent material to reduce the effective index of refraction of the input waveguide adjacent the structure of photodiode material.

19. The photodiode of claim 16, wherein the structure of the photodiode material comprises respective layers of contacts on opposite sides of the photodiode material.

20. The photodiode of claim 16, further comprising:

a second input waveguide at an end of the structure of the photodiode material opposite the input waveguide,
the structure of the photodiode material comprising respective horseshoe-shaped regions at opposite ends joined by a straight region,
the input waveguide and the second input waveguide being respectively tapered to fit between respective arms of the respective horseshoe-shaped regions of the structure of the photodiode material, and
wherein the one or more grooved regions comprise respective grooved regions on respective opposite sides of the input waveguide and the second input waveguide, adjacent the respective arms of the respective horseshoe-shaped regions of the structure of photodiode material.

*100*

*101*

A —————————————— A'

| Si p-contact | Ge PD | Si n-contact |

Top view

Cross-section
through A-A'

*100*

| Si p-contact | Ge PD | Si n-contact |

In-plane
view

PRIOR ART

# FIG. 1A

*101*

*102*

Absorption rate (mW/um)

Propagation axis (um)

PRIOR ART

# FIG. 1B

Bandwidth (GHz)

Optical input power (mW)

PRIOR ART

# FIG. 1C

PRIOR ART

FIG. 2A

PRIOR ART

FIG. 2B

**FIG. 3A**

**FIG. 3B**

**FIG. 3C**

FIG. 4

EP 4 660 673 A1

FIG. 5A

FIG. 5B

600

-1.5 volts bias

FIG. 6A

602

-1 volts bias

FIG. 6B

700

-1 volt bias

FIG. 7

**FIG. 8**

**FIG. 9**

FIG. 10

FIG. 11

FIG. 12

FIG. 13

FIG. 14A

FIG. 14B

FIG. 14C

FIG. 15

FIG. 16

FIG. 17

EP 4 660 673 A1

FIG. 18

FIG. 19

FIG. 20

FIG. 21

EP 4 660 673 A1

FIG. 22A

FIG. 22B

FIG. 22C

FIG. 22D

EP 4 660 673 A1

Europäisches
Patentamt
European
Patent Office
Office européen
des brevets

# EUROPEAN SEARCH REPORT

**Application Number**

EP 25 17 2723

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/278615 A1 (GOTHOSKAR PRAKASH B [US] ET AL) 9 September 2021 (2021-09-09) | 1-3,5-9, 11 | INV. G02B6/12 |
| A | * abstract *<br>* paragraphs [0021] - [0054]; figures 1,3,4,5,6 * | 4,10, 12-16 | G02B6/42 H10F39/10 |
| | ----- | | ADD. |
| X | US 2022/404549 A1 (WELSTAND ROBERT B [US] ET AL) 22 December 2022 (2022-12-22) | 1-9, 11-15 | G02B6/122 |
| A | * abstract *<br>* paragraphs [0036] - [0041]; figures 2A, 2B, 4A, 4B, 6A-C * | 10,16 | |
| | ----- | | |
| X | EP 4 345 918 A1 (IHP GMBH INNOVATIONS FOR HIGH PERFORMANCE MICROELECTRONICS / LEIBNIZ I) 3 April 2024 (2024-04-03) | 1-9 | |
| A | * abstract *<br>* paragraphs [0063] - [0065]; figures 3,4 * | 10-16 | |
| | ----- | | |
| X | US 2022/283391 A1 (ZHANG XINGYU [US] ET AL) 8 September 2022 (2022-09-08) | 1-9 | TECHNICAL FIELDS SEARCHED (IPC) |
| A | * abstract *<br>* paragraphs [0026] - [0064]; figures 1A,4A,5A,8A,8B * | 10-16 | G02B H01L H10F |
| | ----- | | |
| X | US 2018/301570 A1 (HASSAN KARIM [FR] ET AL) 18 October 2018 (2018-10-18) | 1-9 | |
| A | * abstract *<br>* paragraphs [0024] - [0068]; figures 1,2 * | 10-16 | |
| | ----- | | |
| E | EP 4 582 843 A1 (GLOBALFOUNDRIES US INC [US]) 9 July 2025 (2025-07-09)<br>* abstract *<br>* paragraphs [0019] - [0024], [0042]; figures 5,6A * | 16 | |
| | ----- | | |

The present search report has been drawn up for all claims

| Place of search | Date of completion of the search | Examiner |
|---|---|---|
| The Hague | 29 October 2025 | Cohen, Adam |

EPO FORM 1503 03.82 (P04C01)

Europäisches
Patentamt

European
Patent Office

Office européen
des brevets

**Application Number**

**EP 25 17 2723**

---

## CLAIMS INCURRING FEES

The present European patent application comprised at the time of filing claims for which payment was due.

[X] Only part of the claims have been paid within the prescribed time limit. The present European search report has been drawn up for those claims for which no payment was due and for those claims for which claims fees have been paid, namely claim(s):

16

[ ] No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

[ ] All further search fees have been paid within the fixed time limit. The present European search report has been drawn up for all claims.

[ ] As all searchable claims could be searched without effort justifying an additional fee, the Search Division did not invite payment of any additional fee.

[ ] Only part of the further search fees have been paid within the fixed time limit. The present European search report has been drawn up for those parts of the European patent application which relate to the inventions in respect of which search fees have been paid, namely claims:

[ ] None of the further search fees have been paid within the fixed time limit. The present European search report has been drawn up for those parts of the European patent application which relate to the invention first mentioned in the claims, namely claims:

[ ] The present supplementary European search report has been drawn up for those parts of the European patent application which relate to the invention first mentioned in the claims (Rule 164 (1) EPC).

## ANNEX TO THE EUROPEAN SEARCH REPORT
## ON EUROPEAN PATENT APPLICATION NO.

EP 25 17 2723

This annex lists the patent family members relating to the patent documents cited in the above-mentioned European search report.
The members are as contained in the European Patent Office EDP file on
The European Patent Office is in no way liable for these particulars which are merely given for the purpose of information.

29-10-2025

| Patent document cited in search report | | Publication date | Patent family member(s) | | Publication date |
|---|---|---|---|---|---|
| US 2021278615 | A1 | 09-09-2021 | US | 2021157068 A1 | 27-05-2021 |
| | | | US | 2021278615 A1 | 09-09-2021 |
| US 2022404549 | A1 | 22-12-2022 | NONE | | |
| EP 4345918 | A1 | 03-04-2024 | NONE | | |
| US 2022283391 | A1 | 08-09-2022 | NONE | | |
| US 2018301570 | A1 | 18-10-2018 | EP | 3389097 A1 | 17-10-2018 |
| | | | FR | 3065323 A1 | 19-10-2018 |
| | | | US | 2018301570 A1 | 18-10-2018 |
| EP 4582843 | A1 | 09-07-2025 | CN | 120282588 A | 08-07-2025 |
| | | | EP | 4582843 A1 | 09-07-2025 |
| | | | US | 2025224578 A1 | 10-07-2025 |

EPO FORM P0459

For more details about this annex : see Official Journal of the European Patent Office, No. 12/82

**REFERENCES CITED IN THE DESCRIPTION**

**Patent documents cited in the description**

- US 63640313